(19) Europäisches Patentamt / European Patent Office / Office européen des brevets

(11) **EP 1 494 038 B1**

(12) **EUROPÄISCHE PATENTSCHRIFT**

(45) Veröffentlichungstag und Bekanntmachung des Hinweises auf die Patenterteilung:
**29.12.2010 Patentblatt 2010/52**

(51) Int Cl.:
*G01R 31/316* (2006.01)    *G01R 31/27* (2006.01)
*G01R 27/02* (2006.01)

(21) Anmeldenummer: **04013088.2**

(22) Anmeldetag: **03.06.2004**

(54) **Verfahren und Vorrichtung zur Ermittlung des Verhältnisses zwischen einer RC-Zeitkonstanten in einer integrierten Schaltung und einem Sollwert**

Method and device for the determination of the ratio of a RC time constant in an integrated circuit to a set value

Procédé et dispositif pour la détermination de la relation entre la constante de temps RC d'un circuit intégré et une valeur de consigne

(84) Benannte Vertragsstaaten:
**DE FR NL**

(30) Priorität: **02.07.2003 DE 10329856**

(43) Veröffentlichungstag der Anmeldung:
**05.01.2005 Patentblatt 2005/01**

(73) Patentinhaber: **Micronas GmbH**
**79108 Freiburg i. Br. (DE)**

(72) Erfinder:
• **Trojer, Martin**
**9020 Klagenfurt (AT)**
• **Gaier, Ulrich**
**9220 Velden (AT)**

• **Bauer, Achim**
**9500 Villach (AT)**

(74) Vertreter: **Koch Müller**
**Patentanwaltsgesellschaft mbH**
**Maaßstraße 32/1**
**69123 Heidelberg (DE)**

(56) Entgegenhaltungen:
• **PATENT ABSTRACTS OF JAPAN Bd. 017, Nr. 643 (P-1651), 29. November 1993 (1993-11-29) -& JP 05 209929 A (NEC ENG LTD), 20. August 1993 (1993-08-20)**
• **PATENT ABSTRACTS OF JAPAN Bd. 1998, Nr. 13, 30. November 1998 (1998-11-30) -& JP 10 206489 A (FUJITSU LTD), 7. August 1998 (1998-08-07)**

**Beschreibung**

Die vorliegende Erfindung betrifft ein Verfahren und eine Vorrichtung zur Ermittlung des Verhältnisses zwischen einer RC-Zeitkonstante in einer integrierten Schaltung und einem Sollwert.

RC-Netze, die jeweils wenigstens einen ohmschen Widerstand und einen damit verbundenen Kondensator aufweisen, finden vielfach Anwendung. Beispiele hierfür sind Zeitglieder oder Filter. Eine wesentliche, das Verhalten eines solchen RC-Glieds beschreibende Größe ist dessen Zeitkonstante, die sich aus dem Produkt des Kapazitätswertes des kapazitiven Anteils und des Widerstandswertes des ohmschen Anteils ergibt. Abhängig von fertigungsbedingten Schwankungen und/oder den Betriebsbedingungen, unter denen eine ein solches RC-Glied umfassende Schaltung eingesetzt wird, kann diese Zeitkonstante gegenüber einem erwarteten herstellungsbedingten Sollwert erheblich schwanken, wobei Varianzen (Sigma-Werte) von etwa 6% gegenüber dem Sollwert üblich sind.

Aufgrund dieser Schwankungen ist eine Ermittlung der RC-Zeitkonstante vor dem Einsatz einer Schaltung, die solche RC-Glieder umfasst, unerlässlich, um die Schaltung geeignet kalibrieren zu können, wobei diese Kalibrierung abhängig vom geplanten Einsatzzweck einmalig nach der Fertigung der das RC-Glied umfassenden Schaltung oder während des Betriebs mit sich ändernden Einsatzbedingungen erforderlich sein kann.

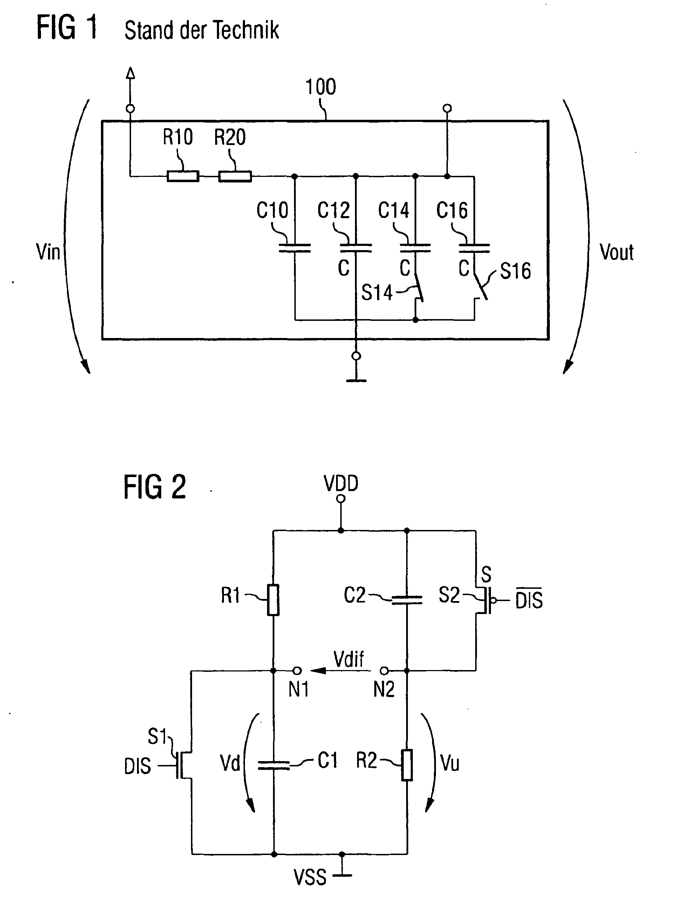

Figur 1 zeigt schematisch einen aus einem RC-Glied bestehenden Tiefpass , der in dem Beispiel eine Reihenschaltung zweier Widerstände R10, R20 und in Reihe zu den Widerständen R10, R20 eine Parallelschaltung mehrerer Kondensatoren C10, C12, C14, C16 umfasst, wobei in dem Beispiel zwei der Kondensatoren C14, C16 wahlweise zu dem RC-Glied hinzuschaltbar oder abschaltbar sind, um das RC-Glied kalibrieren zu können.

Bei bekannten Verfahren zur Ermittlung einer RC-Zeitkonstante, wie beispielsweise aus dem Dokument JP-05209929 A bekannt, werden Lade- und Entladevorgänge des Kondensators eines RC-Glieds durchgeführt, wobei davon ausgegangen wird, dass die RC-Zeitkonstanten weiterer gegebenenfalls in der Schaltung vorhandener RC-Glieder sich bezüglich eines Sollwertes entsprechend wie bei dem gemessenen RC-Glied verhalten. Anhand der Zeit, die benötigt wird, um den Kondensator des Referenzglieds von einem unteren Referenzwert auf einen oberen Referenzwert aufzuladen oder von einem oberen Referenzwert auf einen unteren Referenzwert zu entladen, und in Kenntnis des oberen und unteren Referenzwertes kann die Zeitkonstante ermittelt werden. Die Genauigkeit, mit der bei solchen Verfahren die Zeitkonstante ermittelt werden kann, ist abhängig von der Genauigkeit, mit der die benötigen Zeitreferenzen und Referenzspannungen bereitgestellt werden. Die ermittelten Lade-oder Entladezeiten werden dabei stets mit dem Vielfachen der Taktperiode eines als Zeitreferenz dienenden Taktsignals quantifiziert. Die Genauigkeit bei der Ermittlung der Zeitkonstante steigt dabei mit der Taktfrequenz dieses Taktsignals und mit zunehmender Dauer der Lade- und Entladevorgänge. Eine Verlängerung der Lade- und Entladezeit kann dabei nur durch eine Vergrößerung der Zeitkonstante des Referenz-RC-Glieds erreicht werden, was wiederum einen größeren Widerstand und/oder einen größeren Kondensator und somit einen größeren Flächenbedarf auf dem Chip erfordert.

Ziel der vorliegenden Erfindung ist es, ein Verfahren und eine Vorrichtung zur Ermittlung des Verhältnisses der RC-Zeitkonstante wenigstens eines RC-Glieds in einer integrierten Schaltung zu einem Sollwert zur Verfügung zu stellen, wobei eine möglichst exakte Ermittlung dieses Verhältnisses bei einem geringen Flächenbedarf auf der integrierten Schaltung und bei einem geringen Schaltungsaufwand gewährleistet sein soll.

Dieses Ziel wird durch ein Verfahren gemäß Anspruch 1 und durch eine Vorrichtung gemäß Anspruch 6 gelöst. Vorteilhafte Ausgestaltungen der Erfindung sind Gegenstand der Unteransprüche. Das erfindungsgemäße Verfahren zur Ermittlung des Verhältnisses der RC-Zeitkonstante wenigstens eines RC-Glieds in einer integrierten Schaltung zu einem Sollwert umfasst folgende Verfahrensschritte:

- Das Bereitstellen eines ersten Referenz-RC-Glieds mit einem ersten Widerstand und einem ersten Kondensator und eines zweiten Referenz-RC-Glieds mit einem zweiten Widerstand und einem zweiten Kondensator, die entgegengesetzt zwischen ein erstes und ein zweites Versorgungspotential geschaltet sind, wobei das Produkt aus Widerstandswert und Kapazitätswert der beiden Glieder gleich ist,

- Festlegen einer Norm-RC-Zeitkonstante der beiden Referenz-RC-Glieder,

- Durchführen aufeinanderfolgender Lade- und Entladezyklen während einer vorgegebenen Auswertedauer, wobei die Kondensatoren in einem Zyklus während einer Ladezeit solange geladen werden, bis das Potential an einem dem ersten Widerstand und dem ersten Kondensator des ersten Referenz-RC-Glieds gemeinsamen Knoten wenigstens annäherungsweise dem Potential an einem dem zweiten Widerstand und dem zweiten Kondensator des zweiten Referenz-RC-Glieds gemeinsamen Knoten entspricht, und wobei die Kondensatoren anschließend für eine Entladezeit entladen werden, wobei

- Die Auswertedauer so an die Norm-RC-Zeitkonstante angepasst ist, dass unter der Annahme dass die RC-Zeitkonstante der Referenz-RC-Glieder der Norm-RC-Zeitkonstante entspricht, während dieser Auswertedauer eine vorgegebene Anzahl Lade- und Entladezyklen durchgeführt werden können,

- Ermitteln der tatsächlich durchgeführten Lade- und Entladezyklen,

- Bilden des Quotienten aus der vorgegebenen Anzahl und der ermittelten Anzahl, um ein Maß für das Verhältnis der gemessenen RC-Zeitkonstante zu der Norm-RC-Zeitkonstante zur Verfügung zu stellen.

Vorzugsweise weisen die Widerstände der beiden Referenzglieder jeweils gleiche Widerstandswerte und die Kondensatoren der beiden Referenzglieder jeweils gleiche Kapazitätswerte auf, wodurch das Produkt aus Widerstandswert und Kapazitätswert der beiden Referenzglieder jeweils gleich ist.

Bei dem erfindungsgemäßen Verfahren, bei dem zwei Referenz-RC-Glieder bereitgestellt werden, und bei dem ein Maß für das Verhältnis der RC-Zeitkonstanten dieser RC-Glieder zu einer Norm-RC-Zeitkonstanten ermittelt wird , macht man sich zu Nutze, dass bei einer integrierten Schaltung, die Widerstände und Kondensatoren zur Bildung von RC-Gliedern umfasst, die RC-Zeitkonstanten aller durch diese Widerstände und Kondensatoren gebildeten RC-Glieder im selben Maß relativ von Ihrem Sollwert abweichen, wie die tatsächliche RC-Zeitkonstante der beiden vermessenen Referenzglieder von deren Norm-RC-Zeitkonstante.

Die Entladezeit der Kondensatoren der Referenz-RC-Glieder nach einem Ladevorgang ist vorzugsweise fest vorgegeben, wodurch die Dauer eines einen Ladevorgang und einen Entladevorgang umfassenden Ansteuerzyklus eines Referenzglieds sich aus einer von der RC-Zeitkonstante abhängigen Ladedauer und einer fest vorgegebenen Entladedauer zusammensetzt. Ist die Auswertedauer so gewählt, dass während dieser Auswertedauer N Lade-und Entladevorgänge der Referenzglieder stattfinden können, wenn die Zeitkonstante der Referenzglieder der Norm-Zeitkonstante entspricht, so ergibt das Verhältnis aus dieser vorgegebenen Anzahl N und einer Anzahl P der tatsächlich stattgefundenen Lade- und Entladevorgänge das Verhältnis zwischen der tatsächlichen Zeitkonstante und der Norm-Zeitkonstante. Ist die tatsächliche Zeitkonstante größer als die Norm-Zeitkonstante, so ergeben sich weniger Lade- und Entladevorgänge, das Verhältnis zwischen der vorgegebenen Anzahl N und der tatsächlichen Anzahl P ist somit größer als 1. Ist die Zeitkonstante kleiner als die Norm-Zeitkonstante, so finden während der Auswertedauer mehr Lade- und Entladevorgänge statt, wodurch das Verhältnis aus der vorgegebenen Anzahl und der tatsächlichen Anzahl kleiner als 1 ist.

Zur Ermittlung der Auswertedauer ist vorzugsweise ein Zähler vorgesehen, der durch ein Taktsignal gesteuert ist. Dieser Zähler beginnt mit Beginn der Auswerteperiode im Takt dieses Taktsignals zu zählen, wobei die Auswerteperiode endet, wenn der Zähler seinen Zählerstand um einen Wert erhöht oder verringert hat, der dem Quotienten aus der gewünschten Auswerteperiode und der Taktperiode des Taktsignals entspricht.

Zur Auswertung der Potentiale an dem ersten und zweiten Knoten der Referenzglieder ist vorzugsweise ein Komparator vorgesehen, wobei Ausgangssignale dieses Komparators einen Zähler ansteuern, der zu Beginn der Auswerteperiode zurückgesetzt wird und der am Ende der Auswerteperiode einen der Anzahl der stattgefunden Lade- und Entladezyklen entsprechenden Wert bereitstellt.

Zur Entladung der Kondensatoren der Referenzglieder ist vorzugsweise je ein Schalter parallel zu dem ersten und zweiten Kondensator geschaltet, wobei die Kondensatoren über diese Schalter abhängig von dem Ausgangssignal des Komparators für eine vorgegebene Entladezeit entladen werden.

Die erfindungsgemäße Vorrichtung zur Ermittlung des Verhältnisses zwischen der RC-Zeitkonstante wenigstens eines RC-Glieds in einer integrierten Schaltung und einem Sollwert umfasst folgende Merkmale:

- in der integrierten Schaltung ein erstes Referenz-RC-Glied mit einem ersten Widerstand und einem ersten Kondensator und ein zweites Referenz-RC-Glied mit einem zweiten Widerstand und einem zweiten Kondensator, die entgegengesetzt zwischen ein erstes und ein zweites Versorgungspotential geschaltet sind, wobei das Produkt aus Widerstandswert und Kapazitätswert der Widerstände und Kondensatoren der beiden Glieder jeweils gleich ist,

- einen Komparator mit einem ersten Eingang, der an einem der ersten Widerstand und dem ersten Kondensator gemeinsamen Knoten angeschlossen ist, und mit einem zweiten Eingang, der an einen dem zweiten Widerstand und dem zweiten Kondensator gemeinsamen Knoten angeschlossen ist,

- einen Zähler, dessen Zählerstand innerhalb einer Auswerteperiode getaktet durch ein Ausgangssignal des Komparators erhöht oder verringert wird,

- eine erste und eine zweite Entladeschaltung, die an den ersten und zweiten Kondensator angeschlossen sind und dazu ausgebildet sind, den ersten und zweiten Kondensator abhängig von dem Ausgangssignal des Komparators zu entladen,

- Mittel zur schaltungstechnischen Darstellung eines Quotienten aus einem Sollwert, der ein Maß für eine Norm-RC-Zeitkonstante der Referenz-RC-Glieder darstellt, und einem Ist-Wert, bei dem es sich um die tatsächliche RC-Zeitkonstante handelt.

Die Entladeschaltungen umfassen dabei vorzugsweise jeweils einen parallel zu dem ersten und zweiten Kondensator geschalteten Schalter, wobei diese Schalter abhängig von dem Komparatorausgangssignal jeweils für eine vorgegebene, der Entladezeit entsprechende Zeitdauer geschlossen werden, nachdem ein wenigstens annäherungsweise identisches Potential an dem ersten und zweiten Knoten detektiert wurde.

Mittels des erfindungsgemäßen Verfahrens und der erfindungsgemäßen Vorrichtung wird ein Wert zur Verfügung gestellt, der dem Verhältnis zwischen einer Norm-Zeitkonstante und einer tatsächlichen RC-Zeitkonstante der Referenzglieder entspricht. Dieser Wert kann dazu verwendet werden, die RC-Glieder in der integrierten Schaltung, die beispielsweise Bestandteile von Filtern sind, zu kalibrieren. Ergibt das erfindungsgemäße Verfahren beispielsweise, dass die tatsächliche RC-Zeitkonstante der Referenzglieder um ein ermitteltes Maß prozentual von einem Sollwert abweicht, so ist davon auszugehen, dass auch die RC-Zeitkonstanten der übrigen RC-Glieder in der integrierten Schaltung um dasselbe Maß prozentual von ihrem Sollwert abweichen. Diese gleichmäßigen Abweichungen aller RC-Glieder einer integrierten Schaltung resultieren aus einem gemeinsamen Herstellungsverfahren, das Herstellungstoleranzen unterliegt, oder aus den Umgebungsbedingungen, denen alle RC-Glieder ebenfalls gemeinsam unterliegen. Die aus dem Verhältnis der RC-Konstanten der Referenzglieder zu einem Sollwert erhaltene Information kann zur Kalibrierung der in der integrierten Schaltung neben den Referenzgliedern vorhandenen weiteren RC-Gliedern genutzt werden.

Beispielsweise sind RC-Glieder in integrierten Tiefpassfiltern üblicherweise so aufgebaut, dass der Kondensator des RC-Glieds aus einer Vielzahl parallel geschalteter Kondensatoren besteht, die jeweils denselben Kapazitätswert aufweisen. In Kenntnis der prozentualen Abweichung der RC-Zeitkonstante eines solchen RC-Glieds von einem Sollwert besteht nun die Möglichkeit, einige oder mehrere dieser Kondensatoren abzuschalten oder hinzuzuschalten, um herstellungsbedingte oder umgebungsbedingte Schwankungen auszugleichen und dadurch einen vorgegebenen Wert für die RC-Zeitkonstante einzustellen, die die Eckfrequenz eines als RC-Glied aufgebauten Tiefpassfilters bestimmt.

Die vorliegende Erfindung wird nachfolgend in Ausführungsbeispielen anhand von Figuren näher erläutert.

In den Figuren zeigt

Figur 1     schematisch eine integrierte Schaltung mit ei- nem RC-Glied,

Figur 2     eine Schaltungsanordnung mit zwei Referenz-RC- Gliedern, die entgegengesetzt zwischen ein ers- tes und ein zweites Versorgungspotential ge- schaltet sind,

Figur 3     zeitliche Verläufe der Spannungen an einem ers- ten und einem zweiten Schaltungsknoten der Schaltung gemäß Figur 2,

Figur 4     eine Auswerteschaltung zur Ermittlung eines Verhältnisses der Zeitkonstanten der RC- Glieder gemäß Figur 2 gegenüber einer Norm- Zeitkonstante,

Figur 5     ein schaltungstechnisches Realisierungsbeispiel eines RC-Glieds zur Erläuterung der Kalibrie- rung eines solchen RC-Glieds abhängig von dem mittels des erfindungsgemäßen Verfahrens erhal- tenen Verhältnisses zwischen dem tatsächlichen Wert einer RC-Zeitkonstante eines Referenz- Glieds und einem Sollwert.

In den Figuren bezeichnen, sofern nicht anders angegeben, gleiche Bezugszeichen gleiche Teile mit gleicher Bedeutung. Bei dem erfindungsgemäßen Verfahren zur Ermittlung eines Verhältnisses zwischen einer RC-Zeitkonstante eines RC-Glieds in einer integrierten Schaltung und einem Sollwert für diese Zeitkonstante ist vorgesehen, eine Schaltungsanordnung mit einem ersten Referenz-RC-Glied und einem zweiten Referenz-RC-Glied in der integrierten Schaltung vorzusehen.

Figur 2 zeigt eine solche Schaltungsanordnung mit einem ersten Referenz-RC-Glied, das eine Reihenschaltung eines ersten Widerstandes R1 und eines ersten Kondensators C1 zwischen einem ersten Versorgungspotential VDD und einem zweiten Versorgungspotential VSS umfasst, und mit einem zweiten Referenz-RC-Glied, das einen zweiten Widerstand R2 und einen zweiten Kondensator C2 zwischen dem ersten und zweiten Versorgungspotential VDD, VSS umfasst. Die beiden Referenzglieder sind dabei entgegengesetzt zwischen die Versorgungspotentiale VDD, VSS geschaltet, das heißt, der erste Widerstand R1 und der zweite Kondensator C2 sind gemeinsam an das erste Versorgungspotential VDD und der erste Kondensator C1 und der zweite Widerstand R2 sind gemeinsam an das zweite Versorgungspotential VSS angeschlossen.

Zwischen einem dem ersten Widerstand R1 und dem ersten Kondensator C1 gemeinsamen Knoten N1 des ersten ReferenzGlieds und einem dem zweiten Widerstand R2 und dem zweiten Kondensator C2 gemeinsamen Knoten N2 des zweiten Referenzglieds ist eine Differenzspannung Vdif abgreifbar, die der Differenz aus einer Spannung Vu über dem zweiten Widerstand R2 gegen das zweite Versorgungspotential VSS und einer Spannung Vd über dem ersten Kondensator C1 gegen das zweite Versorgungspotential VSS entspricht.

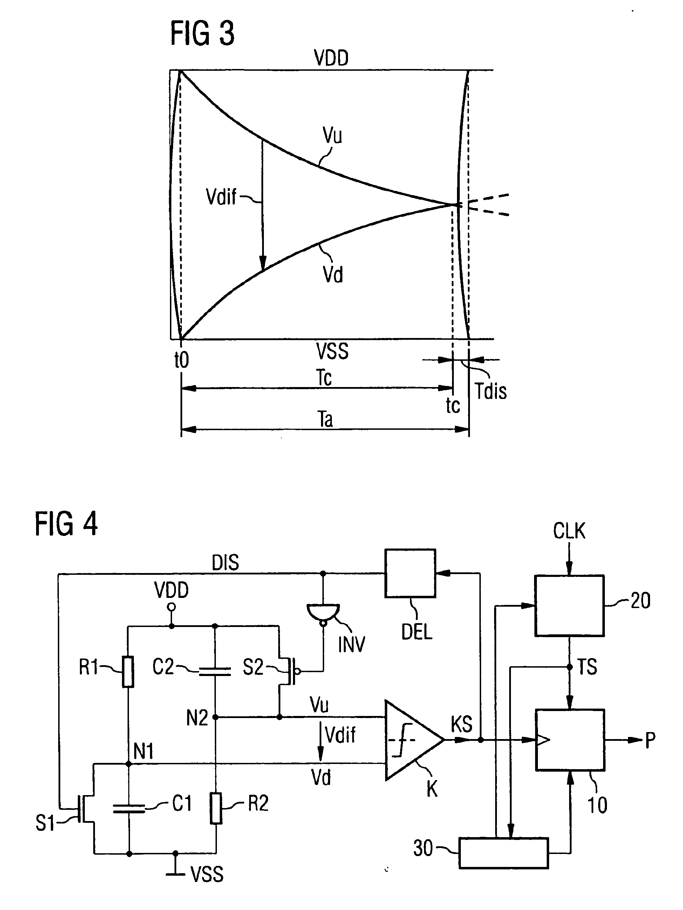

Figur 3 zeigt die zeitlichen Verläufe dieser Spannung Vu und der Spannung Vd für eine Ansteuerperiode, die in Figur 3 zu einem Zeitpunkt t0 beginnt, bei dem der erste und zweite Kondensator C1, C2 vollständig entladen sind. Für die folgende Betrachtung wird davon ausgegangen, dass Widerstände noch zu erläuternder Schalter S1 und S2 vernachlässigbar sind, sodass das Potential an dem zweiten Knoten N2 zum Zeitpunkt t0 dem ersten Versorgungspotential VDD und das Potential an dem ersten Knoten N1 dem zweiten Versorgungspotential VSS entspricht.

Die Entladung des ersten und zweiten Kondensators C1, C2 erfolgt in dem Ausführungsbeispiel durch die Schalter S1, S2, die als Transistoren ausgebildet sind, deren Laststrecken parallel zu den Kondensatoren C1, C2 liegen. Diese Schalter S1, S2 sind vor dem Zeitpunkt t0 geschlossen, um die Kondensatoren C1, C2 zu entladen. Werden die Schalter S1, S2 zum Zeitpunkt t0 geöffnet, so sinkt die Spannung Vu exponentiell ab und die Spannung Vd steigt exponentiell an. Die Kurve der Spannung Vu und die Kurve der Spannung Vd schneiden sich zu einem Zeitpunkt tc, bei dem die Differenzspannung Vdif Null ist. Zu diesem Zeitpunkt gilt:

$$(VDD-VSS) \cdot e^{-(tc-t0)/\tau} + VSS = (VDD-VSS) \cdot (1-e^{-(tc-t0)/\tau}) \qquad (1)$$

$\tau$ bezeichnet dabei die Zeitkonstante jedes der beiden Referenz-RC-Glieder, wobei für diese Zeitkonstante $\tau$ gilt:

$$\tau = R \cdot C, \qquad (2)$$

wobei R den Widerstandswert des ersten und zweiten Widerstandes R1, R2 und C den Kapazitätswert der Kapazität des ersten und zweiten Kondensators C1, C2 bezeichnet.

Setzt man Tc=tc-t0 so folgt durch Auflösen von Gleichung (1) nach Tc:

$$T_c = \tau \cdot \ln(1+(VDD-VSS)/(VDD-VSS)) = \tau \cdot \ln 2 \qquad (3)$$

Die Ladedauer Tc ausgehend vom entladenem Zustand des ersten und zweiten Kondensators C1, C2 bis zur Gleichheit der Spannungen Vu und Vd ist somit proportional zu der RC-Zeitkonstante der beiden Referenzglieder. Ab dem Zeitpunkt tc, bei dem die Differenzspannung Vdif Null wird, werden der erste und zweite Kondensator C1, C2 für eine vorgegebene Zeitdauer die in Figur 3 mit Tdis bezeichnet ist, entladen. Für die Dauer Ta eines Ansteuerzyklus gilt somit:

$$Ta = Tc + Tdis, \qquad (4)$$

wobei Tc von der RC-Zeitkonstante $\tau$ abhängig ist.

Bei dem erfindungsgemäßen Verfahren ist nun vorgesehen, während einer Auswerteperiode T aufeinanderfolgend Lade- und Entladezyklen entsprechend der in Figur 3 dargestellten Weise durchzuführen. Für diese Auswerteperiode T gilt dabei:

$$T = N \cdot (\ln 2 \cdot \tau n + Tdis). \qquad (5)$$

$\tau n$ bezeichnet dabei eine Norm-RC-Zeitkonstante, die einen Sollwert für die Zeitkonstante der Referenz-RC-Glieder gemäss Figur 2 darstellt. Die Auswertedauer T ist also so gewählt, dass während der Auswertedauer N Lade- und Entladezyklen durchgeführt werden könnten, wenn die Zeitkonstante der RC-Glieder der Norm-Zeitkonstante entspricht.

Davon ausgehend, dass die tatsächliche Zeitkonstante dieser Referenzglieder von dem Normwert abweicht gibt es innerhalb der Auswerteperiode P Lade- und Entladezyklen, wobei gilt:

$$P \cdot (\ln2 \cdot \tau + Tdis) = N \cdot (\ln2 \cdot \tau n + Tdis). \qquad (6)$$

Unter der Annahme, dass die Zeitkonstanten $\tau$ und $\tau n$ wesentlich größer als die Entladezeit Tdis ist, folgt aus obiger Beziehung:

$$V = P/N = \tau n/\tau. \qquad (7)$$

Das Verhältnis zwischen der tatsächlichen Zeitkonstante $\tau$ und der Norm-Zeitkonstante $\tau n$ entspricht somit dem Verhältnis aus der vorgegebenen Anzahl N und der Anzahl P der während der Auswerteperiode tatsächlich stattgefundene Lade- und Entladezyklen.

Dieses Verhältnis zwischen der tatsächlichen Zeitkonstante und der Norm-Zeitkonstante der Referenzglieder gilt auch für die Zeitkonstanten aller anderen RC-Glieder der integrierten Schaltung unter der Annahme, dass die zur Realisierung der RC-Glieder verwendeten Widerstände und Kondensatoren durch dieselben Herstellungsprozesse hergestellt wurden und somit denselben herstellungsbedingten Schwankungen unterliegen, wie die Widerstände und Kondensatoren der Referenzglieder.

Figur 4 veranschaulicht eine Vorrichtung zur Durchführung des erfindungsgemäßen Verfahrens. Diese Vorrichtung umfasst neben den bereits erläuterten Referenz-RC-Gliedern mit den Widerständen R1, R2 und den Kondensatoren C1, C2, die entgegengesetzt zwischen das erste und zweite Versorgungspotential VDD, VSS geschaltet sind, einen Komparator K, dessen eine Eingangsklemme an den dem ersten Widerstand R1 und dem ersten Kondensator C1 gemeinsamen Knoten N1 und dessen andere Eingangsklemme an den dem zweiten Widerstand R2 und dem zweiten Kondensator C2 gemeinsamen Knoten N2 angeschlossen ist. Unter der Annahme, dass der an den zweiten Knoten N2 angeschlossene Eingang des Komparators K dessen nicht invertierender Eingang und der an den ersten Knoten N1 angeschlossene Eingang der invertierende Eingang des Komparators K ist, liefert dieser Komparator K ein Ausgangssignal, das jeweils dann eine fallende Flanke aufweist, wenn die Spannung Vu über dem zweiten Widerstand R2 unter die Spannung Vd an dem ersten Kondensator C1 absinkt, wenn die Differenzspannung Vdif also kurzzeitig Null wird. Dem Komparator K ist ein Zeitglied DEL nachgeschaltet, das ein Ausgangssignal DIS bereitstellt, das nach jeder fallenden Flanke des Komparators K für eine der Entladedauer entsprechenden Zeitdauer Tdis einen High-Pegel aufweist, um den ersten und zweiten Schalter S1, S2 für diese Entladezeitdauer Tdis zu schließen und die Kondensatoren C1, C2 zu entladen. Es sei darauf hingewiesen, dass das Zeitglied DEL selbstverständlich auch dazu ausgebildet sein kann, nach jeder steigenden Flanke des Komparatorausgangssignals für die Zeitdauer Tdis einen High-Pegel aufzuweisen.

Dem ersten Schalter S1, der dem Ausführungsbeispiel als n-Kanal-Transistor ausgebildet ist, ist dieses Ausgangssignal DIS des Zeitglieds DEL direkt zugeführt. Der zweite Schalter S2 ist als p-Kanal-Transistor ausgebildet, sodass diesem Schalter S2 das Ausgangssignal des Zeitglieds DEL invertiert über einen Inverter INV zugeführt ist, um diesen Transistor S2 während der Entladezeit Tdis einzuschalten.

Das Ausgangssignal des Komparators K ist außerdem einem Zähler 10 zugeführt, der im Takt dieses Komparatorausgangssignals KS mit jeder fallenden Flanke dieses Signals während einer Auswerteperiode hochgezählt wird. Die Dauer der Auswerteperiode ist vorgegeben durch ein Timersignal TS, das durch einen Timer 20 zur Verfügung gestellt wird und das beispielsweise einen Low-Pegel aufweist, solange der Zähler 10 im Takt des Komparatorausgangssignals KS hochgezählt werden soll.

Der Timer 20 ist beispielsweise ein digitaler Zähler, der dazu ausgebildet ist, im Takt eines Taktsignals CLK seinen Zählerstand zu erhöhen oder zu verringern. Zu Beginn einer Auswerteperiode wird der Zählerstand dabei auf Null gesetzt, und der Zähler wird mit jedem Takt des Taktsignals hochgezählt bis ein die Auswertperiode vorgebender Zählwert erreicht ist. Oder, der Zählerstand des Zählers wird zu Beginn der Auswerteperiode auf den die Auswertedauer vorgebenden Wert gesetzt, und der Zählerstand wird mit jedem Takt des Signals verringert bis der Zählerstand Null erreicht ist. Der die Auswerteperiode vorgebende Zählerstand ist dabei so gewählt, dass der Quotient aus der Auswerteperiode und der Taktperiode des Taktsignals dem Zählerwert entspricht, auf den von Null hochgezählt oder von dem auf Null heruntergezählt wird.

Der Timer stellt ein Timersignal TS zur Verfügung, das den Zähler 10 freigibt, abhängig durch das Komparatorausgangssignal KS hochgezählt zu werden. Dieses Timersignal TS gibt den Zähler 10 zu Beginn des Zählvorgangs frei und sperrt den Zähler 10 bei Erreichen des Zählerendwertes des Timers 20.

Die Vorrichtung umfasst weiterhin eine Ablaufsteuerung 30, die an den Zähler 10 und den Timer-Zähler 20 angeschlossen ist und die den Auswertevorgang startet, wozu der Timer auf Null oder den vorgegebenen Zählerstand gesetzt wird und der Zähler 10 auf Null gesetzt wird.

Am Ende der durch das Timersignal TS vorgegebenen Auswerteperiode wird der Zähler gesperrt, um angesteuert durch das Komparatorsignal KS nicht weiter hochgezählt zu werden, wobei der Zähler 10 seinen Endzählerstand P bis zum Beginn einer nächsten durch die Ablaufsteuerung 30 vorgegebenen Auswerteperiode beibehält und an seinem Ausgang zur Verfügung stellt.

Die Auswerteperiode, während der der Zähler 10 abhängig durch das Ausgangssignal KS des Komparators K hochgezählt wird, ist so auf die Norm-RC-Zeitkonstante und die Entladedauer abgestimmt, dass während der Auswerteperiode genau eine vorgegebene Anzahl Lade- und Entladezyklen durchgeführt werden, wenn die RC-Zeitkonstante der Referenzglieder R1, C1, R2, C2 der Norm-RC-Zeitkonstante entspricht. Weicht die Zeitkonstante der Referenzglieder von der Norm-Zeitkonstante ab, so stellt sich am Ende der Auswerteperiode ein Zählerstand P ein, der von der vorgegebenen Anzahl N abweicht, wobei das Verhältnis aus dem Zählerstand P des Zählers am Ende der Auswerteperiode und der vorgegebenen Anzahl N dem Verhältnis aus der Norm-RC-Zeitkonstante und der tatsächlichen Zeitkonstante der Referenzglieder entspricht.

Dieses Verhältnis aus dem Zählerstand und der vorgegebenen Anzahl ist besonders einfach zu ermitteln, wenn für den vorgegebenen Zählerstand $N=2^n$ gilt und der Zähler 10 als binärer Zähler der Länge n Bit ausgebildet ist. In diesem Fall stellt der binäre Zählerwert unmittelbar ein Maß für das gewünschte Verhältnis zwischen dem Zählerstand des Zählers 10 und dem vorgegebenen Zahlenwert dar, das in der oben erläuterten Weise dem Verhältnis aus der Norm-Zeitkonstante und der tatsächlichen Zeitkonstante entspricht. Das mathematisch exakte Verhältnis wird selbstverständlich dadurch erhalten, dass der Zählerstand P durch die vorgegebene Anzahl N dividiert wird, wobei dieses Ergebnis im Falle $N=2^n$ durch eine bloße "Kommaverschiebung", also eine Interpretation des Bits für $2^n$ als $2^0$, des Bits für $2^{n-1}$ als $2^{-1}$ usw., erhalten wird.

Der Kehrwert dieses erhaltenen Wertes entspricht, dann dem Verhältnis der tatsächlichen Zeitkonstante zu der Norm-RC-Zeitkonstante.

Zur Ermittlung einer Abweichung des Zählerendstandes des Zählers 10 von dem vorgegebenen Wert besteht in diesem Fall die Möglichkeit, das MSB zu streichen, wenn das MSB Eins ist, und das MSB zu streichen und das Zweierkomplement des verbleibenden Wertes zu bilden, wenn das MSB Null ist.

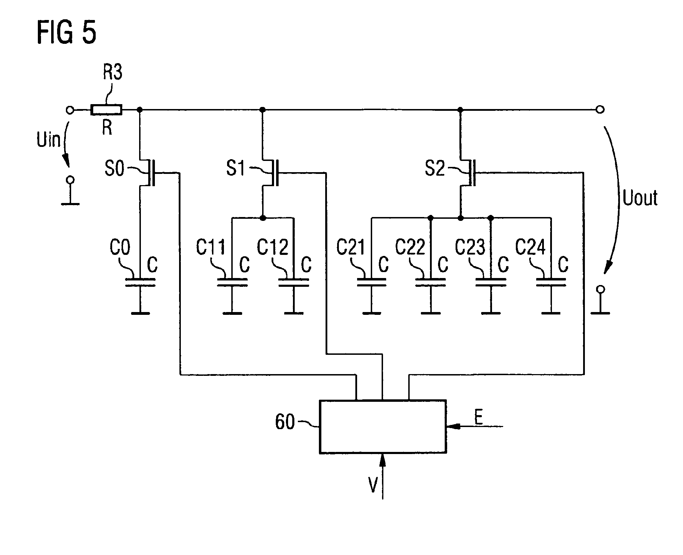

Dieser anhand der Referenz-RC-Glieder ermittelte Verhältniswert V kann beispielsweise zur Kalibrierung von RC-Gliedern in derselben integrierten Schaltung wie die Referenzglieder verwendet werden, wie nachfolgend anhand von Figur 5 erläutert ist.

Figur 5 zeigt ein als Tiefpassfilter dienendes RC-Glied mit einstellbarer RC-Zeitkonstante und somit einstellbarem Frequenzverhalten. Das RC-Glied umfasst einen Widerstand R3 mit einem Widerstandswert R und mehrere Anordnungen mit je einem Schalter S0, S1, S2 und in Reihe zu dem jeweiligen Schalter geschaltete Kondensatoren C0-C24, die jeweils den Kapazitätswert C aufweisen. Diese Kondensatoren sind so angeordnet, dass der Schalter S0 zum Schalten eines $(2^0)$ Kondensators C0, der Schalter S1 zum Schalten zweier $(=2^1)$ parallel geschalteter Kondensatoren C11, C12 und der Schalter S2 zum Schalten von 4 $(=2^2)$ parallel geschalteten Kondensatoren C21-C24 dient. Diese Anordnung ist selbstverständlich beliebig erweiterbar, wobei weitere Schalter jeweils zum Schalten doppelt so vieler parallel geschalteter Kondensatoren wie ein vorheriger Schalter dient. Durch geeignete Ansteuerung der Schalter S0, S1, S2 lässt sich bei diesem RC-Glied eine Zeitkonstante $\tau$ einstellen, die zwischen $\tau=R \cdot C$ und $\tau=7 \cdot R \cdot C$ variiert und die damit Vielfache zwischen 1 und 7 einer Einheitszeitkonstante $\tau_0=R \cdot C$ annimmt. Bei n Schaltern lässt sich so eine Zeitkonstante einstellen, die zwischen $\tau_0$ und $(2^n-1) \cdot \tau_0$ variieren kann.

Zur Einstellung der Zeitkonstante des dargestellten Tiefpassfilters dient eine die Schalter S0, S1, S2 ansteuernde Ansteuereinheit 60, die ein digitales Datenwort bereitstellt, nach dessen Maßgabe die Schalter S0, S1, S2 ein- oder ausgeschaltet werden. Dieses die Schalter S0-S2 ansteuernde und damit die Zeitkonstante bestimmende digitale Datenwort wird abhängig von einem benutzerdefinierten Signal E erzeugt. Mittels dieses Signals kann der Benutzer die RC-Zeitkonstante und damit die Eckfrequenz des Tiefpassfilters einstellen, die proportional zum Kehrwert dieser RC-Zeitkonstante ist.

Der Ansteuereinheit 60 wird darüber hinaus das Verhältnissignal V=P/N zugeführt, um das benutzerdefinierte Signal E abhängig von diesem Verhältnissignal so zu korrigieren, dass sich eine gewünschte Zeitkonstante und damit ein gewünschtes Frequenzverhalten ergibt.

Bezugszeichenliste

| | |
|---|---|
| C0-C24 | Kondensatoren |
| C1, C2 | Kondensatoren |
| C10, C12, C14, C16 | Kondensatoren |
| CLK | Taktsignal |
| DEL | Zeitglied |
| DIS | Entladesignal |

| | |
|---|---|
| INV | Inverter |
| KS | Komparator |
| KS | Komparatorausgangssignal |
| N1, N2 | Schaltungsknoten |
| R1, R2 | Widerstände |
| R10, R20 | Widerstände |
| R3 | Widerstand |
| S1, S2 | Schalter |
| S14, S16 | Schalter |
| Uin | Eingangsspannung |
| Uout | Ausgangsspannung |
| Vd, Vu | Spannungen |
| VDD, VSS | Versorgungspotentiale |
| Vin | Eingangsspannung |
| Vout | Ausgangsspannung |
| 10 | Zähler |
| 20 | Timer |
| 30 | Ansteuerschaltung |
| 40 | Register |
| 50 | Dividierer |
| 60 | Ansteuereinheit |
| 100 | Integrierte Schaltung aus |

**Patentansprüche**

1. Verfahren zur Ermittlung des Verhältnisses der RC-Zeitkonstante wenigstens eines RC-Glieds in einer integrierten Schaltung zu einem Sollwert, wobei das Verfahren folgende Verfahrensschritte umfasst:

   - Bereitstellen eines ersten Referenz-RC-Glieds mit einem ersten Widerstand (R1) und einem ersten Kondensator (C1) und eines zweiten Referenz-RC-Glieds mit einem zweiten Widerstand (R2) und einem zweiten Kondensator (C2), die entgegengesetzt zwischen ein erstes und ein zweites Versorgungspotential (VDD, VSS) geschaltet sind, wobei das Produkt aus Widerstandswert und Kapazitätswert der Widerstände (R1, R2) und der Kondensatoren (C1, C2) der beiden Glieder jeweils gleich ist,
   - Festlegen einer Norm-RC-Zeitkonstante der Referenz-RC-Glieder (R1, C1 und R2, C2),
   - Durchführen aufeinanderfolgender Lade- und Entladezyklen während einer vorgegebenen Auswertedauer, wobei die Kondensatoren (C1, C2) in einem Zyklus während einer Ladezeit so lange geladen werden, bis das Potential an einem dem ersten Widerstand (R1) und dem ersten Kondensator (C1) des ersten Referenz-RC-Glieds gemeinsamen Knoten (N1) wenigstens annäherungsweise dem Potential an einem dem zweiten Widerstand (R2) und dem zweiten Kondensator (C2) des zweiten Referenz-RC-Glieds gemeinsamen Knoten (N2) entspricht, und wobei die Kondensatoren (C1, C2) anschließend für eine Entladezeit entladen werden, wobei
   - die Auswertedauer so an die Norm-RC-Zeitkonstante angepasst ist, dass unter der Annahme, dass die tatsächliche RC-Zeitkonstante der Referenz-RC-Glieder der Norm-RC-Zeitkonstante entspricht, während dieser Auswertedauer eine vorgegebene Anzahl (N) Lade- und Entladezyklen durchgeführt werden können,
   - Ermitteln der Anzahl (P) der tatsächlich durchgeführten Lade- und Entladezyklen,
   - Bereitstellen eines Wertes, der einem Quotienten aus der tatsächlichen Anzahl (P) und der vorgegebenen Anzahl (N) entspricht, um ein Maß für das Verhältnis der Norm-RC-Zeitkonstante zu der RC-Zeitkonstante der Referenz-RC-Glieder zur Verfügung zu stellen.

2. Verfahren nach Anspruch 1, bei dem die Entladezeit (Tdis) fest vorgegeben ist.

3. Verfahren nach Anspruch 1 oder 2, das folgende Verfahrensschritte aufweist:

   - Bereitstellen eines Taktsignals (CLK) mit einer Periodendauer (Tclk), die dem Quotienten aus der Auswertezeit und der vorgegebenen Anzahl (N) entspricht, oder die in einem ganzzahligen Teilerverhältnis zu die diesem Quotienten steht,
   - Starten eines im Takt des Taktsignals zählenden Zählers mit Beginn der Lade- und Entladezyklen,
   - Beenden der Lade- und Entladezyklen, wenn der Zähler seinen Zählerstand um einen der vorgegebenen Anzahl (N) entsprechenden Wert oder um ein ganzzahliges Vielfaches dieses Wertes erhöht oder verringert hat.

4. Verfahren nach einem der vorangehenden Ansprüche, bei dem je ein Schalter (S1, S2) parallel zu dem ersten und zweiten Kondensator (C1, C2) und ein Komparator (K) zum Vergleich der Potentiale an dem ersten und zweiten Knoten (N1, N2) vorgesehen ist, wobei die Schalter (S1, S2) abhängig von einem Komparatorsignal Schalter für eine vorgegebene Entladezeit (Tdis) entladen werden.

5. Verfahren nach einem der vorangehenden Ansprüche bei dem der Komparator (K) einen Zähler (10) ansteuert, der zu Beginn der Lade- und Entladezyklen zurückgesetzt wird und der am Ende der Lade- und Entladezyklen einen der Anzahl der stattgefundenen Lade- und Entladezyklen entsprechenden Wert (P) bereitstellt.

6. Vorrichtung zur Ermittlung des Verhältnisses der RC-Zeitkonstante wenigstens eines RC-Glieds in einer integrierten Schaltung zu einem Sollwert gemäß dem Verfahren nach einem der Ansprüche 1-6, die folgende Merkmale aufweist:

   - in der integrierten Schaltung ein erstes Referenz-RC-Glied mit einem ersten Widerstand (R1) und einem ersten Kondensator (C1) und ein zweites Referenz-RC-Glied mit einem zweiten Widerstand (R2) und einem zweiten Kondensator (C2), die entgegengesetzt zwischen ein erstes und ein zweites Versorgungspotential (VDD, VSS) geschaltet sind, wobei das Produkt aus Widerstandswert und Kapazitätswert der Widerstände (R1, R2) und der Kondensatoren (C1, C2) der beiden Glieder jeweils gleich ist,
   - einen Komparator (K) mit einem ersten Eingang, der an einen dem ersten Widerstand (R1) und dem ersten Kondensator (C1) gemeinsamen Knoten (N1) angeschlossen ist, und mit einem zweiten Eingang, der an einen dem zweiten Widerstand (R2) und dem zweiten Kondensator (C2) gemeinsamen Knoten (N2) angeschlossen ist,
   - einen Zähler (10), dessen Zählerstand innerhalb einer Auswerteperiode getaktet durch ein Ausgangssignal des Komparators (K) erhöht oder verringert wird,
   - eine erste und eine zweite Entladeschaltung (S1, S2), die an den ersten und zweiten Kondensator (C1, C2) angeschlossen sind und dazu ausgebildet sind, den ersten und zweiten Kondensator (C1, C2) abhängig von dem Ausgangssignal des Komparators zu entladen,
   - Mittel zur Ermittlung eines Quotienten und aus dem Zählerstand (P) des Zählers (10), , , der einer tatsächlichen Anzahl von durchgeführten Lade- und Entladezyklen entspricht, , einem Sollwert (N), der ein Maß für eine Norm-RC-Zeitkonstante der Referenz-RC-Glieder darstellt.

7. Vorrichtung nach Anspruch 6, bei dem die Entladeschaltungen jeweils einen parallel zu dem ersten und zweiten Kondensator (C1, C2) geschalteten Schalter (S1, S2) aufweisen.

8. Verwendung des in dem Verfahren nach einem der vorangehenden Ansprüche ermittelten Quotienten zur Einstellung der RC-Zeitkonstante eines Filters.

**Claims**

1. Method of determining the relationship of the resistance-capacitance time constant of at least one resistance-capacitance element in an integrated circuit to a target value, wherein the method comprises the following method steps:

   - providing a first reference resistance-capacitance element with a first resistor (R1) and a first capacitor (C1) and a second reference resistance-capacitance element with a second resistor (R2) and a second capacitor (C2), which are oppositely connected between a first and a second supply potential (VDD, VSS), wherein the product of resistance value and capacitance value of the resistors (R1, R2) and capacitors (C1, C2) of the two elements is the same,
   - fixing a standard resistance-capacitance time constant of the reference resistance-capacitance elements (R1, C1 and R2, C2),
   - carrying out successive charging and discharging cycles during a predetermined evaluating period, wherein the capacitors (C1, C2) are charged in a cycle during a charging time until the potential at a junction (N1) common to the first resistor (R1) and the first capacitor (C1) of the first reference resistance-capacitance element at least approximately corresponds with the potential at a junction (N2) common to the second resistor (R2) and the second capacitor (C2) of the second reference resistance-capacitance element, and wherein the capacitors (C1, C2) are subsequently discharged for a discharge time, wherein
   - the evaluating period is so matched to the standard resistance-capacitance time constant that on the assumption that the actual resistance-capacitance time constant of the reference resistance-capacitance elements corresponds with the standard resistance-capacitance time constant a predetermined number (N) of charging and discharging cycles can be carried out during this evaluating period,
- determining the number (P) of the actually performed charging and discharging cycles and
- providing a value corresponding with a quotient of the actual number (P) and the predetermined number (N) so as to provide a measure for the relationship of the standard resistance-capacitance time constant to the resistance-capacitance time constant of the reference resistance-capacitance elements.

2. Method according to claim 1, in which the discharge time (Tdis) is fixedly preset.

3. Method according to claim 1 or 2, comprising the following method steps:

- providing a clock signal (CLK) with a periodic duration (Tclk) which corresponds with the quotient of the evaluating time and the predetermined number (N) or which has an integral divisor relationship to this quotient,
- starting a counter, which counts in the rhythm of the clock signal, at the start of the charging and discharging cycles and
- ending the charging and discharging cycles when the counter has increased or reduced its count state by a value corresponding with the predetermined number (N) or by an integral multiple of this value.

4. Method according to any one of the preceding claims, in which a respective switch (S1, S2) is provided in parallel with the first and second capacitors (C1, C2) and a comparator (K) for comparing the potentials at the first and second junctions (N1, N2), wherein the switches (S1, S2) are discharged in dependence on a comparator signal switch for a predetermined discharge time (Tdis).

5. Method according to any one of the preceding claims, in which the comparator (K) activates a counter (10) which is reset at the beginning of the charging and discharging cycles and which at the end of the charging and discharging cycles provides a value (P) corresponding with the number and discharging cycles which have taken place.

6. Device for determining the relationship of the resistance-capacitance time constant of at least one resistance-capacitance element in an integrated circuit to a target value in accordance with the method according to any one of claims 1 to 6, comprising the following features:

- in the integrated circuit, a first reference resistance-capacitance element with a first resistor (R1) and a first capacitor (C1) and a second reference resistance-capacitance element with a second resistor (R2) and a second capacitor (C2), which are oppositely connected between a first and a second supply potential (VDD, VSS), wherein the product of resistance value and capacitance value of the resistors (R1, R2) and the capacitors (C1, C2) of the two elements is the same,
- a comparator (K) with a first input, which is connected with a junction (N1) common to the first resistor (R1) and the first capacitor (C1) and with a second input, which is connected with a junction (N2) common to the second resistor (R2) and the second capacitor (C2),
- a counter (10), the count state of which is increased or reduced within an evaluating period cycled by an output signal of the comparator (K),
- a first and a second discharge circuit (S1, S2), which are connected with the first and second capacitors (C1, C2) and which are constructed for the purpose of discharging the first and second capacitors (C1, C2) in dependence on the output signal of the comparator and
- means for determining a quotient from the count state (P) of the counter (10), which corresponds with an actual number of charging and discharging cycles performed, and a target value (N) which represents a measure for a standard resistance-capacitance time constant of the reference resistance-capacitance elements.

7. Device according to claim 6, in which the discharge circuits each comprise a switch (S1, S2) connected in parallel with the first and second capacitors (C1, C2).

8. Use of the quotient, which is determined in the method according to any one of the preceding claims, for setting the resistance-capacitance time circuit of a filter.

**EP 1 494 038 B1**

**Revendications**

1. Procédé pour la détermination de la relation entre la constante de temps RC d'au moins un élément RC dans un circuit intégré et une valeur de consigne, le procédé comprenant les étapes de procédé suivantes :

   - fourniture d'un premier élément RC de référence, avec une première résistance (R1) et un premier condensateur (C1), et d'un deuxième élément RC de référence, avec une deuxième résistance (R2) et un deuxième condensateur (C2), montés de manière opposée entre un premier et un deuxième potentiel d'alimentation (VDD, VSS), le produit de la valeur de résistance et de la valeur de capacité des résistances (R1, R2) et des condensateurs (C1, C2) des deux organes étant à chaque fois identique,
   - fixation d'une constante de temps RC normée des éléments RC de référence (R1, C1, et R2, C2)
   - accomplissement de cycles de charge et de décharge successifs, pendant une durée d'évaluation prédéterminée, les condensateurs (C1, C2) étant chargés au cours d'un cycle, pendant un temps de charge, jusqu'à ce que le potentiel à un noeud (N1) commun à la première résistance (R1) et au premier condensateur (C1) du premier élément RC de référence corresponde au moins à peu près au potentiel à un noeud (N2) commun à la deuxième résistance (R2) et au deuxième condensateur (C2) du deuxième élément RC de référence, et où les condensateurs (C1, C2) sont ensuite déchargés pendant un temps de décharge, où
   - la durée d'évaluation est adaptée à la constante de temps normée de manière que, en supposant que la constante de temps RC effective des éléments RC de référence corresponde à la constante de temps normée, pendant cette durée d'évaluation, un nombre (N) prédéterminé de cycles de charge et de décharge peuvent être accomplis,
   - détermination du nombre (P) de cycles de charge et de décharge accomplis effectivement,
   - fourniture d'une valeur, correspondant à un quotient entre le nombre effectif (P) et le nombre prédéterminé (N), pour mettre à disposition une indication quantitative pour la relation entre la constante de temps RC normée et la constante de temps RC des éléments RC de référence.

2. Procédé selon la revendication 1, dans lequel le temps de décharge (Tdis) est prédéterminé à une valeur fixe.

3. Procédé selon la revendication 1 ou 2, présentant les étapes de procédé suivantes :

   - fourniture d'un signal de cadencement (CLK) d'une durée de période (Tclk), correspondant au quotient entre la valeur d'évaluation et le nombre prédéterminé (N), ou située dans un rapport de diviseur, étant un nombre entier, par rapport à celle de ce quotient,
   - lancement d'un compteur, comptant à la cadence du signal de cadencement, avec le début des cycles de charge et de décharge,
   - achèvement des cycles de charge et de décharge, lorsque le compteur a augmenté ou diminué sa valeur de compteur d'une valeur, correspondant au nombre prédéterminé (N), ou d'un multiple entier de cette valeur.

4. Procédé selon l'une des revendications précédentes, dans lequel à chaque fois un interrupteur (S1, S2) est prévu parallèlement au premier et au deuxième condensateur (C1, C2), et un comparateur (K), pour effectuer la comparaison des potentiels au premier et au deuxième noeud (N1, N2), les interrupteurs (S1, S2) étant déchargés en fonction d'un interrupteur de signal de comparateur pour un temps de décharge (Tdis) prédéterminé.

5. Procédé selon l'une des revendications précédentes, dans lequel le comparateur (K) commande un compteur (10) qui, au début des cycles de charge et de décharge, est ramené à l'état initial et, à la fin des cycles de charge et de décharge, fournit une valeur (P) correspondant au nombre des cycles de charge et de décharge s'étant effectués.

6. Dispositif pour la détermination de la relation entre la constante de temps RC d'au moins un élément RC dans un circuit intégré et une valeur de consigne, suivant le procédé selon l'une des revendications 1 à 6, présentant les caractéristiques suivantes :

   - dans le circuit intégré, un premier élément RC de référence, avec une première résistance (R1) et un premier condensateur (C1) et un deuxième élément RC de référence, avec une deuxième résistance (R2) et un deuxième condensateur (C2), sont montés de manière opposée entre un premier et un deuxième potentiel d'alimentation (VDD, VSS), le produit de la valeur de résistance et de la valeur de capacité des résistances (R1, R2) et des condensateurs (C1, C2) des deux organes étant à chaque fois identique,
   - un comparateur (10), avec une première entrée, raccordée à un noeud (N1) commun à la première résistance (R1) et au premier condensateur (C1), et avec une deuxième entrée, raccordée à un noeud (N2) commun à la

11

deuxième résistance (R2) et au deuxième condensateur (C2)

- un compteur (10), dont l'état de compteur est augmenté ou diminué, de manière cadencée, dans les limites d'une période d'évaluation, au moyen d'un signal de sortie du comparateur (K),

- un premier et un deuxième circuit de décharge (S,S2), raccordés au premier et au deuxième condensateur (C1, C2) et réalisés pour décharger le premier et le deuxième condensateur (C1, C2) en fonction du signal de sortie du comparateur,

- des moyens, pour déterminer un quotient, entre l'état de compteur (P) du compteur (10), correspondant à un nombre effectif de cycles de charge et de décharge effectuées, et une valeur de consigne (N), constituant une indication quantitative d'une constante de temps RC normée des éléments RC de référence.

7. Dispositif selon la revendication 6, dans lequel les circuits de décharge présentent chacun un interrupteur (S1, S2), branché en parallèle au premier et au deuxième condensateur (C1, C2).

8. Utilisation du quotient, déterminé dans le procédé selon l'une des revendications précédentes, pour le réglage de la constante de temps RC d'un filtre.

EP 1 494 038 B1

FIG 1  Stand der Technik

FIG 2

13

## FIG 3

## FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 05209929 A